# FASCICULE DE BREVET EUROPEEN

(11) **EP 4 350 919 B1**
(45) Date de publication et mention de la délivrance du brevet: **06.05.2026**
(21) Numéro de dépôt: 23200823.5
(22) Date de dépôt: 29.09.2023
(51) Int. Cl.: H02H 9/00, H02M 1/36, H03K 17/081, H03K 17/082, H02M 1/32

(54) **PROCEDE ET CIRCUIT DE MISE SOUS TENSION D'UN CIRCUIT ELECTRIQUE**
VERFAHREN UND SCHALTUNGSANORDNUNG ZUM EINSCHALTEN EINER ELEKTRISCHEN SCHALTUNG
METHOD AND CIRCUIT FOR SWITCHING ON AN ELECTRIC CIRCUIT

(30) Priorité: 07.10.2022 FR 2210275
(43) Date de publication de la demande: 10.04.2024
(73) Titulaire: STMicroelectronics (Rousset) SAS, 13790 Rousset (FR)
(72) Inventeur: CALANDRA, Antonio, 83470 SAINT MAXIMIN LA SAINTE BAUME (FR); CASTELLAN, Julia, 13530 TRETS (FR); BIENVENU, Philippe, 83470 SAINT MAXIMIN LA SAINTE BAUME (FR)
(74) Mandataire: Cabinet Beaumont

(56) Documents cités:
- US-A1- 2015 357 811
- US-A1- 2019 181 862
- US-A1- 2022 103 069
- US-B1- 8 299 767
- US-B2- 7 064 946
- US-B2- 9 306 559

## Description

### Domaine technique

La présente description concerne de façon générale un procédé et un circuit pour la mise sous tension d'un circuit électrique comprenant une charge capacitive élevée.

### Technique antérieure

Dans certains domaines, tel que par exemple le domaine automobile, des circuits électriques comprennent des charges capacitives importantes devant être chargées à la mise sous tension des circuits. L'alimentation de la charge capacitive se fait par exemple depuis une batterie et par l'intermédiaire d'un transistor de puissance. Par exemple, les charges capacitives comprennent des dispositifs à alimenter, qui peuvent être associés à des capacités, et comprennent également des conducteurs capacitifs qui relient le transistor de puissance vers les dispositifs à alimenter. Il est souhaitable que le chargement des charges capacitives du circuit soit relativement rapide afin que les dispositifs soient opérationnels dans un temps relativement court.

D'un côté, l'application d'une densité de courant élevée sur le transistor de puissance lors de l'alimentation d'un circuit électrique permet un chargement rapide des charges capacitives. Cependant, une densité de courant élevée peut être vue par le circuit comme étant due à un court-circuit, et déclenche donc des mécanismes de protection. De plus, l'application d'une densité de courant élevée fatigue certains composants, dont le transistor de puissance.

De l'autre côté, l'application d'une densité de courant trop faible peut placer le transistor de puissance dans une zone d'instabilité thermique du courant et ainsi le dégrader.

Il existe un problème technique pour charger efficacement les charges capacitives de capacités élevées lors de la mise sous tension d'un circuit électrique, sans placer le transistor de puissance alimentant les charges capacitives dans un état d'instabilité thermique, et tout en surveillant le risque de court-circuit et en évitant d'appliquer une trop haute densité de courant pouvant dégrader d'autres composants du circuit.

Un document US 2022/0103069 décrit une méthode de démarrage progressif pour un régulateur à découpage. Un document US 2019/181862 décrit un circuit et un système mettant en œuvre un fusible pour alimentation électrique. Un document 2015/357811 décrit un dispositif enfichable à chaud permettant d'activer des transistors à effet de champ avec une capacité de démarrage progressif. Un document US 9 306 559 décrit un système pour contrôler l'activation des transistors à effet de champ d'un dispositif enfichable à chaud.

### Résumé de l'invention

Il existe un besoin d'améliorer les méthodes et les circuits de chargement des charges capacitives d'un circuit électrique lors de sa mise sous tension.

Un mode de réalisation pallie tout ou partie des inconvénients des méthodes de chargement connues.

Un mode de réalisation prévoit un procédé de démarrage électrique d'un circuit, le procédé comprenant :
- l'application, par un circuit de commande, d'un premier signal d'impulsions, formé de premières impulsions consécutives de tension, vers la grille d'un transistor de puissance, le transistor de puissance alimentant une charge capacitive du circuit, les impulsions du premier signal d'impulsions étant séparées par un premier temps de repos ;
- suite à une ou plusieurs des impulsions du premier signal, une comparaison, par un comparateur, de la valeur de la tension à travers la charge capacitive avec une première valeur seuil de tension ; et
- si la première valeur seuil de tension est dépassée, l'application, par le circuit de commande, d'un deuxième signal d'impulsions, formé de deuxièmes impulsions consécutives de tension, vers la grille du transistor de puissance alimentant la charge capacitive du circuit, les impulsions du deuxième signal d'impulsions étant séparées par un deuxième temps de repos inférieur au premier temps de repos;
- suite à une ou plusieurs des impulsions du deuxième signal, une deuxième comparaison, par le comparateur, de la valeur de la tension à travers la charge capacitive avec la première valeur seuil de tension ;
- si, lors de la deuxième comparaison, la valeur de tension est inférieure ou égale à la première valeur seuil de tension, l'arrêt, par le circuit de commande, du deuxième signal d'impulsions.

Selon un mode de réalisation, le procédé ci-dessus comprend en outre :
- suite à une ou plusieurs des impulsions du deuxième signal, une comparaison, par le comparateur, de la valeur de la tension à travers la charge capacitive avec une deuxième valeur seuil de tension ;
- si la valeur de tension est égale ou supérieure à la deuxième valeur seuil de tension, l'arrêt, par le circuit de commande, du deuxième signal d'impulsions.

Selon un mode de réalisation, le procédé ci-dessus comprend en outre :
- suite à une ou plusieurs impulsions du premier signal d'impulsions et si la valeur de la tension à travers la charge capacitive est inférieure à la première valeur seuil de tension, l'incrémentation par un compteur du circuit d'une première valeur de comptage ; et
- si la valeur de comptage est égale à une première valeur de référence, l'arrêt, par le circuit de commande, du premier signal d'impulsions.

Selon un mode de réalisation, le procédé comprend en outre :
- suite à une ou plusieurs impulsions du deuxième signal d'impulsions, l'incrémentation par un compteur du circuit d'une deuxième valeur de comptage ; et
- si la deuxième valeur de comptage est égale à une deuxième valeur de référence, l'arrêt, par le circuit de commande, du deuxième signal d'impulsions.

Selon un mode de réalisation, le circuit de commande applique chaque impulsion du premier signal d'impulsions au transistor de puissance, en faisant :
- l'application d'un premier front rendant le transistor de puissance conducteur ;
- la vérification, par un circuit de détection, d'un premier niveau de courant conduit par le transistor de puissance ; et
- lorsque le premier niveau de courant atteint un niveau seuil, l'application d'un deuxième front rendant le transistor de puissance non conducteur.

Selon un mode de réalisation, le circuit de commande applique chaque impulsion du deuxième signal d'impulsions au transistor de puissance, en faisant :
- l'application d'un troisième front rendant le transistor de puissance conducteur ;
- la vérification, par le circuit de détection, d'un deuxième niveau courant conduit par le transistor de puissance ; et
- lorsque le deuxième niveau de courant atteint le niveau seuil, l'application d'un quatrième front rendant le transistor de puissance non conducteur.

Selon un mode de réalisation, le niveau seuil correspond à un niveau de courant pour lequel le coefficient thermique du transistor de puissance est négatif.

Selon un mode de réalisation, le circuit de commande applique chaque impulsion du premier signal d'impulsions au transistor de puissance, en faisant :
- l'application d'un premier front rendant le transistor de puissance conducteur ;
- la comparaison, par un détecteur thermique du circuit, de la température du transistor de puissance ; et
- lorsque la température du transistor atteint une température seuil, l'application d'un deuxième front rendant le transistor de puissance non conducteur.

Selon un mode de réalisation, au moins une valeur parmi : la première valeur seuil de tension ; la valeur du premier temps de repos ; et la valeur du deuxième temps de repos, est déterminée par une valeur stockée dans une mémoire programmable du circuit.

Un mode de réalisation prévoit un circuit comprenant :
- un transistor de puissance configuré pour alimenter une charge capacitive du circuit ;
- un circuit de commande configuré pour appliquer un premier signal d'impulsions étant formé de premières impulsions consécutives de tension séparées par un premier temps de repos, vers la grille du transistor de puissance ; et
- un comparateur configuré pour comparer, suite à une ou plusieurs des impulsions du premier signal, la valeur de la tension à travers la charge capacitive avec une première valeur seuil de tension,
le circuit de commande étant en outre configuré pour, si la première valeur seuil de tension est dépassée, appliquer un deuxième signal d'impulsions formé de deuxièmes impulsions consécutives de tension séparées par un deuxième temps de repos, vers la grille du transistor de puissance alimentant la charge capacitive du circuit, le deuxième temps de repos étant inférieur au premier temps de repos; le comparateur étant en outre configuré pour, suite à une ou plusieurs des impulsions du deuxième signal, effectuer une deuxième comparaison de la valeur de la tension à travers la charge capacitive avec la première valeur seuil de tension et dans lequel le circuit de commande est en outre configuré pour, si lors de la deuxième comparaison la valeur de tension est inférieure ou égale à la première valeur seuil de tension, arrêter le deuxième signal d'impulsions.

Un mode de réalisation prévoit un système comprenant :
- un transformateur configuré pour alimenter un boitier de commutation ;
- le boitier de commutation comprenant le circuit ci-dessus.

Selon un mode de réalisation, le transformateur et le boitier de commutation font partie d'une automobile.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma par bloc illustrant un système configuré pour alimenter des charges capacitives d'un circuit électrique selon un mode de réalisation de la présente description ;
la figure 2 illustre un exemple de circuit implémentant un boitier de commutation de la figure 1 selon un mode de réalisation de la présente description ;
la figure 3 est un graphique illustrant des zones de stabilité et d'instabilité thermique d'un transistor de puissance ;
la figure 4 est un organigramme illustrant des étapes d'un procédé de mise sous tension d'un circuit électrique comprenant une charge capacitive selon un mode de réalisation de la présente description ;
la figure 5A est un graphique temporel illustrant un courant conduit par le transistor de puissance selon un mode de réalisation de la présente description ;
la figure 5B est un graphique temporel illustrant l'évolution de la tension aux bornes de la charge capacitive selon un mode de réalisation de la présente description ;
la figure 6A est un graphique temporel illustrant un courant conduit par le transistor de puissance selon un autre mode de réalisation de la présente description ; et
la figure 6B est un graphique temporel illustrant l'évolution de la tension aux bornes de la charge capacitive selon un mode de réalisation de la présente description.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, le fonctionnement des transistors de puissance n'est pas décrit en détail et est connu par la personne du métier.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

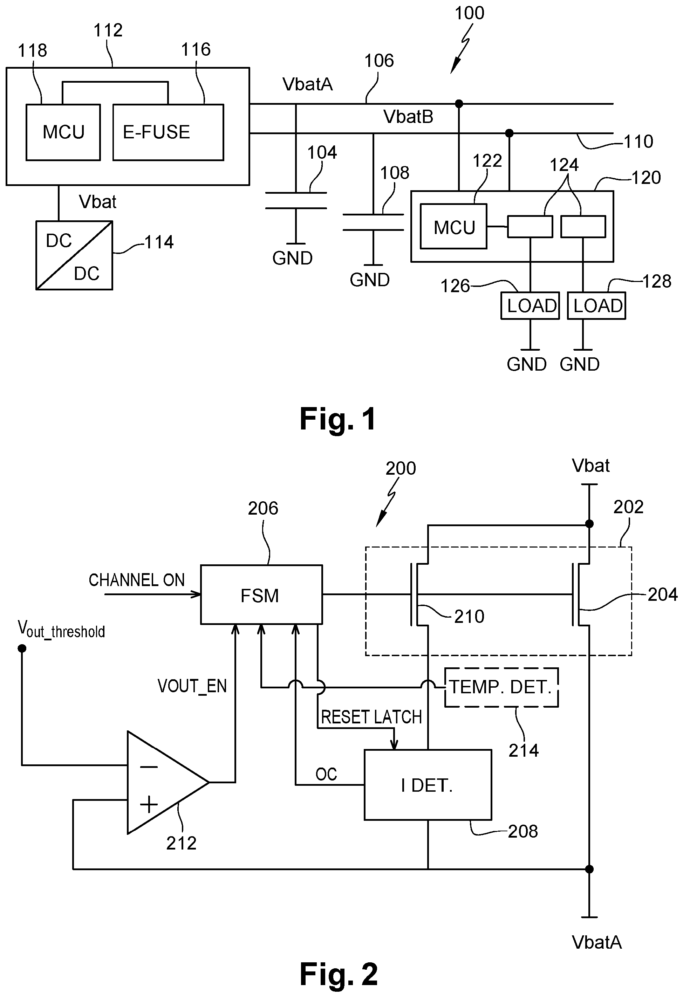

La figure 1 est un schéma par bloc illustrant un système 100 configuré pour alimenter des charges capacitives 104 et 108 d'un circuit électrique selon un mode de réalisation de la présente description. Le système 100 fait par exemple partie d'un dispositif plus grand (non illustré), tel que par exemple le système électrique d'une automobile, ayant une charge capacitive élevée.

A titre d'exemple, la charge capacitive 104, représentée par un condensateur relié à la masse (GND), est alimentée par un premier rail 106, et la charge capacitive 108, qui est représentée par un autre condensateur relié à la masse (GND), est alimentée par un deuxième rail 110. Bien que seulement deux charges capacitives 104 et 108 et deux rails 106 et 110 sont illustrés en figure 1, il est bien sûr possible que le système 100 comprenne un nombre supérieur de charges capacitives, chacune alimentée par un rail correspondant.

Le système 100 comprend en outre un boitier de commutation 112, ainsi qu'un transformateur 114 (DC/DC) configuré pour alimenter le boitier de commutation 112 en lui appliquant une tension Vbat. Par exemple, le transformateur 114 reçoit une tension DC d'entrée d'une source DC (non illustrée dans la figure 1), tel qu'une batterie, et génère la tension Vbat ayant un niveau de tension différent de la tension DC d'entrée. Dans d'autres modes de réalisation, le transformateur 114 n'est pas présent, et le boitier de commutation 112 est alimenté directement par la batterie.

Le boitier de commutation 112 comprend par exemple un circuit électrique 116 (E-FUSE) configuré pour, par exemple, alimenter les rails 106 et 110 par l'intermédiaire d'un ou plusieurs transistors de puissance.

Le boitier de commutation 112 comprend, par exemple en outre, une unité de traitement 118 (MCU) configurée pour piloter le circuit électrique 116, par exemple afin de gérer l'alimentation de différents composants alimentés par le circuit 116.

Le système 100 comprend par exemple en outre un circuit 120 couplé au boitier de commutation 112 par l'intermédiaire des rails 106 et 110. Le circuit 120 comprend par exemple une unité de traitement 122 (MCU) ainsi que des circuits électriques 124. A titre d'exemple, le circuit 120 est un dispositif comprenant un ou plusieurs autres circuits électriques. Le circuit 120 alimente par exemple d'autres charges 126 et 128 (LOAD) couplées à la masse (GND).

Lors de l'allumage du système 100, c'est à dire lorsque le transformateur 114 met sous tension le boitier de commutation 112, le circuit 116 est alors commandé pour alimenter les rails 106 et 110 en leur appliquant respectivement une tension VbatA et VbatB. Dans un premier temps, les charges capacitives 104 et 108 sont chargées afin que l'ensemble des circuits alimentés par les rails 106, 110 soient fonctionnels, y compris le circuit 120. Il est donc souhaitable que les charges capacitives 104 et 108 soient chargées rapidement.

Dans certaines applications, par exemple lorsque le système 100 est intégré dans une automobile, la charge capacitive totale du système 100 a une capacité élevée, par exemple une capacité supérieure à 1 mF (milli-Farad). L'application d'une haute densité de courant en sortie du boitier de commutation 112 sur les rails 106 et 110 permet de charger rapidement les charges capacitives 104 et 108 mais peut fatiguer et/ou dégrader certains composants, comme des transistors de puissances et/ou des circuits imprimés. Additionnellement, l'application d'un haut courant peut être vue par le dispositif comme étant due à un court-circuit, et déclenche donc des mécanismes de protection.

Néanmoins, lorsqu'une densité de courant trop faible est appliquée par l'intermédiaire d'un transistor de puissance compris par exemple dans le boitier de commutation 112, cela peut dégrader le transistor de puissance en le plaçant dans un état d'instabilité thermique du courant engendrant un emballement thermique.

La figure 2 illustre un circuit 200 compris dans le circuit 116 du boitier de commutation 112 de la figure 1 selon un mode de réalisation de la présente description. Le circuit 200 de la figure 2 est configuré pour alimenter le rail 106. Un circuit similaire au circuit 200 est par exemple également présent dans le boitier de commutation 112 pour alimenter le rail 110.

Le circuit 200 comprend un transistor de puissance 202 dont le drain est par exemple couplé au rail de tension alimenté par le transformateur 114 lui appliquant la tension Vbat. La source du transistor de puissance 200 est couplée au rail 106 et lui applique une tension VbatA. Le transistor de puissance 202 comprend par exemple une pluralité de transistors en parallèle, dont deux sont illustrés dans la figure 2 avec des références 204 et 210. A titre d'exemple les transistors 204 et 210 compris dans le transistor de puissance 202 sont des transistors à canal N (NMOS) de type MOSFET (de l'anglais « Metal Oxide Semiconductor Field Effect Transistor »).

Le circuit 200 comprend en outre un circuit de commande 206 (FSM) couplé à la grille du transistor de puissance 202. Le circuit de commande 206 est implémenté par exemple par une machine à états finis. Le circuit de commande 206 reçoit par exemple un signal CHANNEL_ON indiquant quand le rail 106 est à alimenter. Par exemple, le signal CHANNEL_ON est généré par l'unité de traitement 118.

Le circuit 200 comprend en outre un circuit de détection 208 (I DET.), par exemple agencé pour relier le drain du transistor de puissance 210 au rail 106. Une sortie du circuit de détection 208 est par exemple reliée au circuit de commande 206.

Le circuit de détection 208 est par exemple configuré pour comparer le courant traversant le transistor 210 avec un courant seuil. Le transistor 210 est par exemple d'une taille relativement petite par rapport à la taille globale du transistor de puissance 202, et conduit donc uniquement une partie relativement faible du courant total fourni par le transistor de puissance 202. Le niveau de courant détecté par le circuit de détection 208 est néanmoins proportionnel au courant total conduit par le transistor de puissance 202. A titre d'exemple, le courant seuil correspond à une densité de courant dans le transistor de puissance 202 pour laquelle le transistor de puissance 202 est dans un état de stabilité thermique.

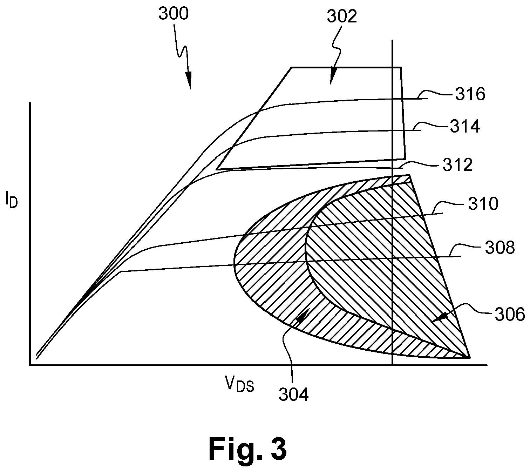

La figure 3 est un graphique 300 illustrant une zone de stabilité thermique 302 et des zones d'instabilité thermique 304 et 306 d'un transistor de puissance tel que le transistor 202 de la figure 2. La zone 304 correspond par exemple à un premier niveau d'instabilité du transistor de puissance, tandis que la zone 306 correspond par exemple à un niveau d'instabilité accrue pour lequel un phénomène d'emballement thermique a lieu. Le coefficient thermique du transistor de puissance 200, définie comme étant la variation du courant en fonction de la température, est négatif pour la zone 302 et est positif pour les zones 304 et 306.

En particulier, le graphique 300 présente cinq courbes 308 à 316 illustrant la relation entre la tension *V_{DS}* entre le drain et la source du transistor et le courant *I_{DS}* circulant entre le drain et la source pour différentes valeurs de tensions *V_{GS}* entre la grille et la source du transistor et à différentes températures.

Les courbes 308 et 310 illustrent respectivement la relation *V_{DS}* et *I_{DS}* lorsque la tension *V_{GS}* est égale à 3 V et à des températures de 25°C et 125°C. Le courant *I_{DS}* croît linéairement avec la tension *V_{DS}* puis la croissance est rapidement ralentie lorsque le transistor de puissance est saturé. Le courant *I_{DS}* reste relativement faible et le transistor 210 rentre tout d'abord dans la zone d'instabilité 304, par exemple lorsque la tension *V_{DS}* est dans une première plage de tension, puis dans la zone d'instabilité 306, par exemple lorsque la tension *V_{DS}* dépasse la limite haute de la première plage de tension. Lorsque le transistor 210 entre dans la zone d'instabilité 306, le phénomène d'emballement thermique a lieu, menant par exemple à des problèmes de focalisation du courant et à la formation de points chauds dégradant de manière définitive le transistor de puissance 202.

La courbe 312 représente la relation entre le courant *I_{DS}* et la tension *V_{DS}* lorsque la tension *V_{GS}* est égale à 6 V et à des températures de 25°C et de 125°C. Dans cet exemple, la courbe 312 passe entre les zones 304 et 302.

Les courbes 314 et 316 illustrent respectivement la relation *V_{DS}* et *I_{DS}* lorsque la tension *V_{GS}* est égale à 8 V et à des températures de 125°C et 25°C. En particulier, le coude des courbes 314 et 316, séparant la zone de croissance linéaire entre courant *I_{DS}* et la tension *V_{DS}* et la zone de saturation dans laquelle le courant *I_{DS}* croit moins rapidement, apparait pour une valeur du courant *I_{DS}* beaucoup plus haute que pour les courbes 308 et 310. En particulier, pour les exemples illustrés par les courbes 314 et 316, la saturation du transistor de puissance a lieu lorsque le courant *I_{DS}* est suffisamment grand pour placer le transistor de puissance dans la zone de stabilité thermique.

En référence à nouveau à la figure 2, selon un mode de réalisation, le circuit de commande 206 est configuré pour appliquer des signaux d'impulsions de tension à la grille du transistor de puissance 202. Chaque réception d'une impulsion de tension place les transistors 204 et 210 dans l'état passant, permettant ainsi le chargement, avec une haute densité de courant pendant au moins une partie de l'impulsion, de la charge capacitive 104. Lorsque le courant traversant le transistor 210 atteint la valeur seuil, le circuit de détection 208 est configuré pour activer un signal de dépassement de courant OC (en anglais "over current") vers le circuit de commande 206, et le circuit de commande 206 est configuré pour commander, en réponse au signal OC, le passage des transistors 204 et 210 à l'état bloquant. Le circuit de commande 206 est en outre configuré pour repasser les transistors 204 et 210 à l'état passant suite à un temps de repos, permettant ainsi une nouvelle impulsion du signal d'impulsions. Le temps de repos permet au transistor de puissance 202 de, par exemple, refroidir suffisamment pour ne pas surchauffer.

Selon un mode de réalisation, le circuit 200 comprend un comparateur 212 configuré pour comparer la tension VbatA sur le rail 106 avec une valeur seuil de tension *V_{out_th}.* Le comparateur 212 est en outre configuré pour transmettre un signal VOUT_EN au circuit de commande 206 lorsque la valeur de la tension VbatA atteint la valeur seuil de tension *V_{out_th}.* La comparaison est par exemple réalisée de manière continue. Dans un autre exemple, le comparateur 212 est configuré pour comparer les valeurs des tensions VbatA et *V_{out_th}* de manière périodique, par exemple suite à un nombre donné d'impulsions consécutives.

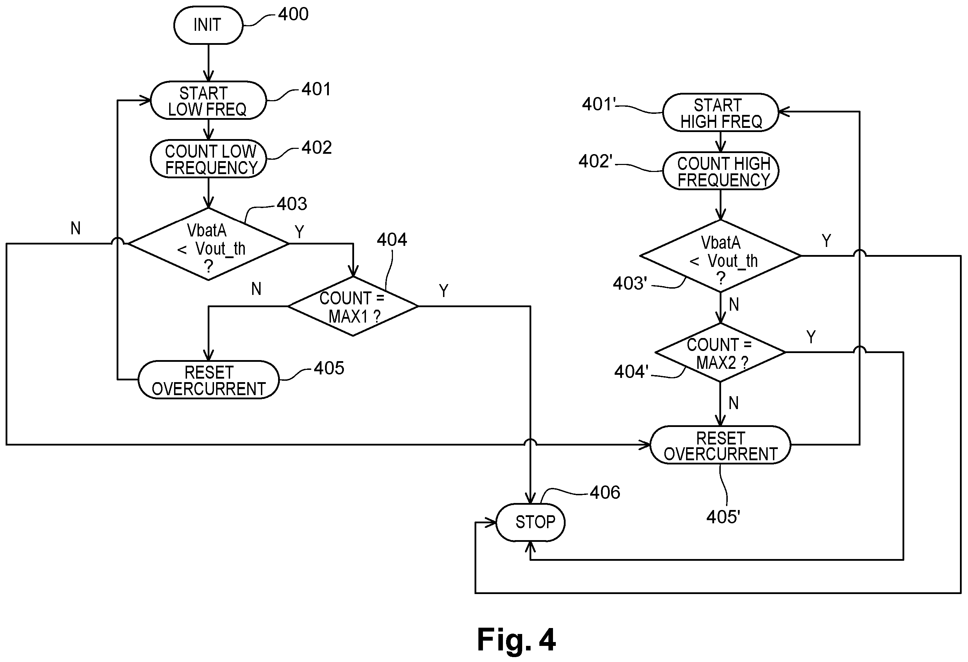

La figure 4 est un organigramme illustrant des étapes d'un procédé de mise sous tension du circuit électrique 200 alimentant le rail 106, selon un mode de réalisation de la présente description.

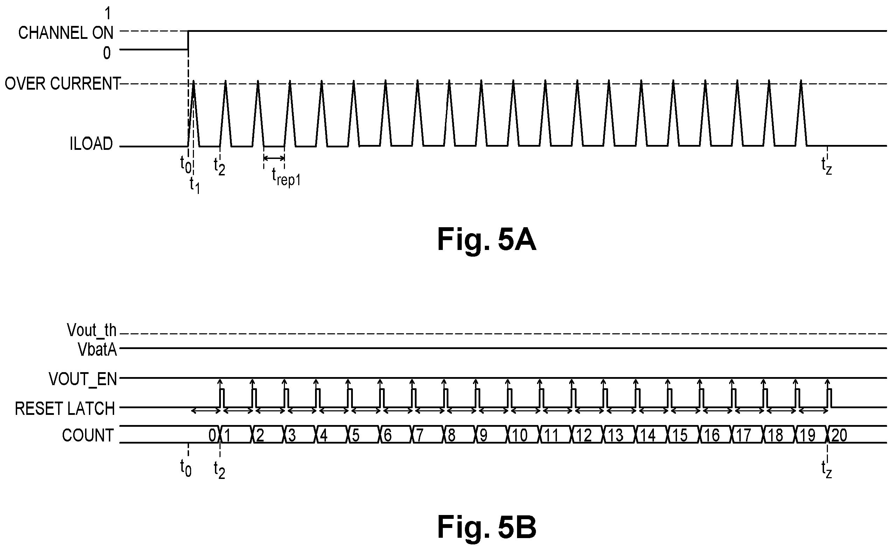

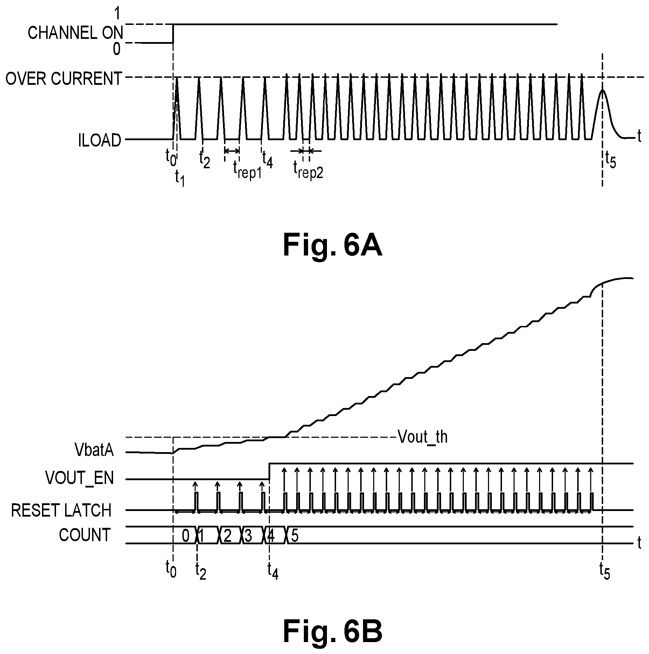

Les figures 5A et 6A sont des graphiques temporels illustrant la densité de courant conduite par le transistor de puissance 202 selon un mode de réalisation de la présente description.

Les figures 5B et 6B sont des graphiques temporels illustrant l'évolution de la tension VbatA selon un mode de réalisation de la présente description.

Dans une étape 400 (INIT) de la figure 4, le circuit 200 n'est pas alimenté par le transformateur 112. Le transistor de puissance 202 n'est par conséquent pas alimenté et n'alimente pas le rail 106.

Selon un mode de réalisation, le boitier de commutation 112 comprend un compteur (non illustré en figure 2) configuré pour incrémenter une valeur de comptage COUNT qui est par exemple initialisée à la valeur 0 lorsque le circuit 200 n'est pas alimenté.

Selon un mode de réalisation, le procédé de mise sous tension du circuit 116 se décompose en deux phases. Une première phase, par exemple composée d'une suite d'étapes 401 à 405, correspondant à une alimentation du rail 106 par un signal d'impulsions à relativement basse fréquence. Dans le cas où aucune anomalie n'ait été détectée, la première phase est suivie par une deuxième phase par exemple composée d'une suite d'étapes 401' à 405', correspondant à une alimentation du rail 106 par un signal d'impulsions à relativement haute fréquence, c'est-à-dire à une fréquence d'impulsions supérieure à celle du signal d'impulsions à relativement basse fréquence.

Comme illustré dans les figures 5A et 6A, la mise sous tension du circuit 200 provoque par exemple la réception, à un instant *t*₀, du signal CHANNEL_ON, par exemple transmis par l'unité de traitement 118 au circuit de commande 206.

Dans l'étape 401 (START LOW FREQ) de la figure 4, débutant à l'instant *t*₀ à réception du signal CHANNEL_ON, le circuit de commande 206 envoie un front de tension au transistor de puissance 202 afin de le placer dans l'état passant. Dans le cas où le transistor de puissance 202 est implémenté par un transistor à canal P, ce front de tension est par exemple un front descendant. Dans un autre cas où le transistor de puissance est implémenté par un transistor à canal N, ce front de tension est par exemple un front montant. Le transistor de puissance 202 reste dans l'état passant jusqu'à ce que le circuit de détection 208 envoie le signal OC au circuit de commande 206, signalant que le courant ILOAD traversant le transistor de puissance 202 a atteint une valeur seuil OVER_CURRENT. A titre d'exemple, la valeur seuil est stockée dans une mémoire programmable du circuit 200 couplée au circuit de détection 208. Sur les exemples illustrés en figures 5A, 5B, 6A et 6B, la génération du signal OC a par exemple lieu à un instant *t*₁. A la réception du signal OC, le circuit de commande 206 est en outre configuré pour appliquer un autre front de tension au transistor de puissance 202 afin de le placer dans l'état bloquant. Dans le cas où le transistor de puissance est implémenté par un transistor à canal P, ce front de tension est par exemple un front ascendant. Suite au passage du transistor de puissance 202 à l'état bloquant, le courant ILOAD diminue de façon continue jusqu'à devenir nul.

Suite à la réception du signal OC et dans une étape 402 (COUNT LOW FREQUENCY), un chronomètre, ou un compteur d'unité de temps, du circuit 200 (non illustré en figure 2) est déclenché.

A titre d'exemple, le chronomètre est par exemple configuré pour chronométrer un premier laps de temps. A titre d'exemple, le premier laps de temps est de l'ordre de 4 ms. Le chronomètre est en outre configuré pour signaler au circuit de commande 206 que le premier laps de temps s'est écoulé depuis la réception du signal OC, lorsque c'est le cas. Dans certains cas, le premier laps de temps est programmable. Par exemple, une valeur représentant le premier laps de temps est stockée dans la mémoire programmable, et le chronomètre est configuré pour lire cette valeur dans la mémoire programmable et pour signaler au circuit de commande 206 quand ce laps de temps s'est écoulé. Le premier laps de temps fixe par exemple un temps de repos *t*_{*rep*1} entre les impulsions pendant la première phase.

Une fois que le premier laps de temps est écoulé, le circuit de commande 206 vérifie, dans une étape 403 (VbatA<*V_{out_th}*?), sur la base du signal de sortie du comparateur 212, si la valeur de la tension VbatA est inférieure à la valeur seuil de tension *V_{out_th}.* A titre d'exemple, la valeur seuil de tension *V_{out_th}* est stockée dans la mémoire programmable et est convertie par un convertisseur numérique analogique vers la tension analogique *V_{out_th}.* L'étape 403 comprend en outre l'incrémentation de la valeur de comptage COUNT.

Si la valeur de tension VbatA est inférieure à la valeur seuil *V_{out_th}* (branche Y), le procédé continue dans une étape 404 (COUNT1=MAX1?) dans laquelle la valeur de comptage COUNT est comparée, par exemple par l'unité de traitement 118, avec une première valeur maximale. Si la valeur de comptage COUNT n'est pas égale à la première valeur maximale (branche N), le procédé continue dans une étape 405 (RESET OVERCURRENT). A titre d'exemple, la première valeur maximale est stockée dans la mémoire programmable.

Dans les exemples illustrés par les figures 5A, 5B, 6A et 6B, l'étape 405 a lieu à un instant *t*₂.

Dans l'étape 405 (RESET OVERCURRENT), le circuit de commande 206 génère un signal RESET LATCH commandant la réinitialisation du circuit de détection 208, et donc la remise à zéro du signal de dépassement de courant OC. Dans un premier exemple, le signal RESET LATCH force la remise à zéro du signal de dépassement OC, et le signal RESET LATCH reste actif durant un laps de temps relativement court avant d'être éteint, ce laps de temps étant choisi pour être inférieur au temps de montée des pics de courants. A titre d'exemple, le signal RESET LATCH reste actif durant un temps, par exemple inférieur à 20us et de préférence inférieur à 10us. Dans un autre exemple, le signal RESET LATCH est un signal non prioritaire par rapport à la détection de dépassement de courant par le circuit de détection 208. Dans ce cas, si le circuit de détection 208 détecte un dépassement de courant alors que le signal RESET LATCH est actif, le circuit de détection 208 active néanmoins le signal de dépassement de courant OC. Le procédé reprend alors à l'étape 401.

Dans l'exemple illustré par les figures 5A et 5B, le procédé continue ainsi, dans une suite de réalisation des étapes 401 à 405, jusqu'à une réalisation de l'étape 405, à un instant *t*₃, dans laquelle la valeur de comptage COUNT atteint la valeur maximale (branche N en sortie de l'étape 404). La valeur maximale est par exemple égale à 20. Néanmoins, toute autre valeur entière est envisageable comme valeur maximale. Dans ce cas, le procédé se termine dans une étape 406 (STOP).

En effet, si suite à l'application d'un nombre égal à la valeur maximale d'impulsions du premier signal, la tension VbatA n'a toujours pas dépassée la valeur seuil de tension *V_{out_th},* cela traduit un problème au sein du système 100 tel que par exemple un court-circuit. L'étape 406 consiste alors, par exemple, en la mise hors tension du circuit 116 ou du boitier de commutation 112.

Dans l'exemple illustré par les figures 6A et 6B, la tension VbatA atteint la valeur seuil de tension *V_{out_th}* (branche N en sortie de l'étape 403) à un instant *t*₄. Dans cet exemple, la valeur de comptage est alors égale à 4 et est inférieure à la valeur maximale. Comme la tension VbatA atteint la valeur seuil de tension relativement rapidement, cela traduit que le rail 106 est correctement alimenté et qu'aucun court-circuit n'a lieu.

Lorsque, dans l'étape 403, il est déterminé que le rail 106 est correctement alimenté et que le transistor de puissance 202 supporte l'alimentation et n'est pas en court-circuit, le temps de repos entre deux impulsions de tension est réduit, et/ou le cycle de service des impulsions est augmenté, afin d'accélérer l'augmentation de la tension sur le rail 106.

A titre d'exemple, lorsque la valeur de la tension VbatA atteint la valeur *V_{out_th},* la valeur de comptage COUNT est réinitialisée, par exemple à 0.

Le procédé continue alors dans une étape 405' (RESET OVERCURRENT), similaire à l'étape 405 et dans laquelle le circuit de détection 208 est alors réinitialisé.

Le procédé continue ensuite dans la suite d'étapes 401' à 404'. L'étape 401' (START HIGH FREQ) est similaire à l'étape 401 et consiste en l'application, par le circuit de commande 206, d'un front de tension rendant le transistor de puissance 202 passant. Le circuit de commande 206 applique ensuite un autre front de tension, rendant le transistor de puissance 202 bloquant, à la réception du signal OC.

L'étape 402' (COUNT HIGH FREQUENCY) est similaire à l'étape 402 excepté que le chronomètre est configuré pour signaler au circuit de commande 206, qu'un deuxième laps de temps s'est écoulé depuis la réception du signal OC, lorsque c'est le cas. La valeur du deuxième laps de temps est par exemple stockée dans la mémoire programmable. De plus, la valeur du deuxième laps de temps est inférieure à la valeur du premier laps de temps. Le deuxième laps de temps est par exemple de l'ordre de 1 ms. Le deuxième laps de temps fixe par exemple un temps de repos *t*_{*rep*2} entre les impulsions pendant la deuxième phase, le temps de repos *t*_{*rep*2} étant inférieur au temps de repos *t*_{*rep*1}*.* Ainsi, le temps de repos du transistor de puissance 202 entre son passage à l'état bloquant et le moment où il est replacé dans l'état passant est plus rapide que durant la première phase d'alimentation. Le chargement de la charge capacitive 104 est alors accéléré.

L'étape 403' est similaire à l'étape 403.

Si, lors de la réalisation de l'étape 403', le comparateur 212 détermine que la tension VbatA devient inférieure à la valeur seuil de tension *V_{out_th}* (branche Y), le procédé se termine à l'étape 406. En effet, si la tension VbatA redevient inférieure à la valeur seuil *V_{out_th},* un problème, tel que par exemple un court-circuit, a par exemple lieu dans le système 100.

L'étape 404' (COUNT=MAX2 ?) fait suite à l'étape 403' lorsque la tension VbatA est toujours supérieure à la valeur seuil *V_{out_th}* (branche Y). L'étape 404' est similaire à l'étape 404, à l'exception que la valeur de comptage est comparée avec une deuxième valeur maximale. La deuxième valeur maximale est par exemple stockée dans la mémoire programmable. Dans un autre exemple, la deuxième valeur maximale est égale à la première valeur maximale et les étapes 404' et 404 sont identiques.

Comme dans la première phase d'alimentation, si lors de l'étape 404' la valeur de comptage est égale à la deuxième valeur maximale (branche Y), cela signifie que le rechargement de la charge capacitive 104 prend trop de temps et qu'une anomalie a lieu. Le procédé se termine alors dans l'étape 406.

Si, dans l'étape 404' la valeur de comptage n'est pas égale à la deuxième valeur maximale (branche N), le procédé reprend à l'étape 401'.

Dans l'exemple illustré par les figures 6A et 6B, la suite d'étapes 401' à 405' est réalisée jusqu'à un instant *t*₅, ayant par exemple lieu durant la réalisation de l'étape 401'. L'instant *t*₅ correspond à l'instant où la charge capacitive 104 est complétement chargée, et la tension VbatA reste alors constante. A titre d'exemple, le circuit de commande 206 est en outre configuré pour détecter l'instant où la charge capacitive 104 est complètement chargée et pour, par exemple, laisser le transistor 202 dans l'état passant afin d'alimenter en continu les dispositifs tels que par exemple le circuit 120. Dans un autre exemple, le circuit 200 comprend un autre comparateur configuré pour comparer la tension VbatA avec une tension maximale Vmax correspondant à la tension sur le rail 106 lorsque la charge capacitive 104 est complétement chargée. A titre d'exemple, la valeur de la tension Vmax est stockée dans la mémoire programmable.

Dans l'exemple illustré par les figures 6A et 6B, le rail 106 est alimenté par un signal à une première fréquence d'impulsions de tension, appliqué par le circuit de commande 206. Le signal à la première fréquence d'impulsions est émis entre les instants *t*₀ et *t*₄. Le rail 106 est ensuite alimenté par un nouveau signal, à une deuxième fréquence d'impulsions supérieure à la première fréquence, émis par le circuit de commande 206 entre les instants *t*₄ et *t*₅. Le temps de repos *t*_{*rep*1} entre chaque impulsion du signal à la première fréquence d'impulsions de tension est supérieure au temps de repos *t*_{*rep*2} entre chaque impulsion du signal à la deuxième fréquence d'impulsions. Le temps de repos entre deux impulsions correspond, par exemple, au temps entre la fin d'une impulsion et le début de l'impulsion suivante. De plus, la durée d'une impulsion de courant varie relativement peu pendant le chargement de la charge capacitive 104. Les impulsions de tension du signal à la première fréquence ont alors, par exemple, une durée similaire aux impulsions de tension du signal à la deuxième fréquence. Ainsi, le cycle de service du signal à la première fréquence d'impulsions est, par exemple, plus petit que le cycle de service du signal à la deuxième fréquence d'impulsions.

Selon un autre mode de réalisation, le circuit 200 comprend, en plus du circuit de détection 208, ou à la place du circuit de détection 208, un détecteur thermique configuré pour comparer la température du circuit 200, et plus particulièrement la température du transistor de puissance 202 avec une température seuil. Le détecteur thermique est par exemple couplé au circuit de commande 206 et configuré en outre pour lui transmettre un signal lorsque la température mesurée excède la température seuil. Le circuit de commande 206 est par exemple configuré pour couper l'alimentation du transistor de puissance 202 à réception du signal transmis par le détecteur thermique.

Un avantage des modes de réalisations décrits est qu'ils permettent un chargement rapide des charges capacitives d'un circuit, tout en surveillant les risques de court-circuit et en évitant de placer le transistor de puissance dans un état d'instabilité thermique. Le courant étant une valeur continue et la pulsation de courant fournie par le transistor de puissance démarrant de 0, le transistor de puissance a automatiquement une phase de transition dans une zone d'instabilité thermique. Néanmoins, le laps de temps passé dans la zone d'instabilité thermique est négligeable par rapport aux constantes thermiques et ne laisse pas le temps au transistor de puissance de se dégrader.

Un autre avantage des modes de réalisation décrits est que le temps de repos entre impulsions diminue, et/ou le cycle de service du signal d'impulsions augmente, lorsque le risque de court-circuit est écarté.

Un autre avantage des modes de réalisation décrits est que l'alimentation des rails par des signaux d'impulsions entrecoupées par des temps de repos permet au transistor de puissance 202 de ne pas surchauffer et de supporter une alimentation par un haut courant mais de manière discontinue.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, un compteur et une valeur de comptage peuvent être utilisés lors de la première phase d'alimentation et un autre compteur, incrémentant une autre valeur de comptage, ou de manière alternative, le même compteur incrémentant l'autre valeur de comptage, peuvent être utilisés lors de la deuxième phase d'alimentation.

Enfin, la mise en oeuvre pratique des modes de réalisation et variantes décrits est à la portée de la personne du métier à partir des indications fonctionnelles données ci-dessus. En particulier, les indications de durée des différents temps de repos du transistor de puissance sont données à titre illustratif et ne sont pas limitatives.

## Revendications

1. Procédé de démarrage électrique d'un circuit (200), le procédé comprenant :
- l'application, par un circuit de commande (206), d'un premier signal d'impulsions, formé de premières impulsions consécutives de tension, vers la grille d'un transistor de puissance (202), le transistor de puissance alimentant une charge capacitive du circuit (104), les impulsions du premier signal d'impulsions étant séparées par un premier temps de repos ;
- suite à une ou plusieurs des impulsions du premier signal, une comparaison, par un comparateur (212), de la valeur de la tension (VbatA) à travers la charge capacitive avec une première valeur seuil de tension (*V_{out_th}*) ; et
- si la première valeur seuil de tension est dépassée, l'application, par le circuit de commande, d'un deuxième signal d'impulsions, formé de deuxièmes impulsions consécutives de tension, vers la grille du transistor de puissance alimentant la charge capacitive du circuit, les impulsions du deuxième signal d'impulsions étant séparées par un deuxième temps de repos inférieur au premier temps de repos ;
**caractérisé en ce que** le procédé comprend en outre:
- suite à une ou plusieurs des impulsions du deuxième signal, une deuxième comparaison, par le comparateur, de la valeur de la tension à travers la charge capacitive avec la première valeur seuil de tension ;
- si, lors de la deuxième comparaison, la valeur de tension est inférieure ou égale à la première valeur seuil de tension, l'arrêt, par le circuit de commande, du deuxième signal d'impulsions.

2. Procédé selon la revendication 1, comprenant en outre :
- suite à une ou plusieurs des impulsions du deuxième signal, une comparaison, par le comparateur (212), de la valeur de la tension (VbatA) à travers la charge capacitive (104) avec une deuxième valeur seuil de tension (Vmax) ;
- si la valeur de tension est égale ou supérieure à la deuxième valeur seuil de tension, l'arrêt, par le circuit de commande (206), du deuxième signal d'impulsions.

3. Procédé selon la revendication 1 ou 2, comprenant en outre :
- suite à une ou plusieurs impulsions du premier signal d'impulsions et si la valeur de la tension (VbatA) à travers la charge capacitive (104) est inférieure à la première valeur seuil de tension (*V_{out_th}*), l'incrémentation par un compteur du circuit d'une première valeur de comptage (COUNT) ; et
- si la valeur de comptage est égale à une première valeur de référence, l'arrêt, par le circuit de commande (206), du premier signal d'impulsions.

4. Procédé selon l'une quelconque des revendications 1 à 3, comprenant en outre :
- suite à une ou plusieurs impulsions du deuxième signal d'impulsions, l'incrémentation par un compteur du circuit d'une deuxième valeur de comptage ; et
- si la deuxième valeur de comptage est égale à une deuxième valeur de référence, l'arrêt, par le circuit de commande (206), du deuxième signal d'impulsions.

5. Procédé selon l'une quelconque des revendications 1 à 4, dans lequel le circuit de commande (206) applique chaque impulsion du premier signal d'impulsions au transistor de puissance (202), en faisant :
- l'application d'un premier front rendant le transistor de puissance conducteur ;
- la vérification, par un circuit de détection (208), d'un premier niveau de courant (ILOAD) conduit par le transistor de puissance ; et
- lorsque le premier niveau de courant atteint un niveau seuil (OVERCURRENT), l'application d'un deuxième front rendant le transistor de puissance non conducteur.

6. Procédé selon la revendication 5, dans lequel le circuit de commande (206) applique chaque impulsion du deuxième signal d'impulsions au transistor de puissance (202), en faisant :
- l'application d'un troisième front rendant le transistor de puissance conducteur ;
- la vérification, par le circuit de détection (208), d'un deuxième niveau courant (ILOAD) conduit par le transistor de puissance ; et
- lorsque le deuxième niveau de courant atteint le niveau seuil (OVERCURRENT), l'application d'un quatrième front rendant le transistor de puissance non conducteur.

7. Procédé selon la revendication 5 ou 6, dans lequel le niveau seuil (OVERCURRENT) correspond à un niveau de courant pour lequel le coefficient thermique du courant du transistor de puissance (202) est négatif.

8. Procédé selon l'une quelconque des revendications 1 à 7, dans lequel le circuit de commande (206) applique chaque impulsion du premier signal d'impulsions au transistor de puissance (202), en faisant :
- l'application d'un premier front rendant le transistor de puissance conducteur ;
- la comparaison, par un détecteur thermique (214) du circuit (200), de la température du transistor de puissance (202) ; et
- lorsque la température du transistor atteint une température seuil, l'application d'un deuxième front rendant le transistor de puissance non conducteur.

9. Procédé selon l'une quelconques des revendications 1 à 8, dans lequel, au moins une valeur parmi : la première valeur seuil de tension (*V_{out_th}*) *;* la valeur du premier temps de repos ; et la valeur du deuxième temps de repos, est déterminée par une valeur stockée dans une mémoire programmable du circuit.

10. Circuit (200) comprenant :
- un transistor de puissance (202) configuré pour alimenter une charge capacitive (104) du circuit ;
- un circuit de commande (206) configuré pour appliquer un premier signal d'impulsions étant formé de premières impulsions consécutives de tension séparées par un premier temps de repos, vers la grille du transistor de puissance ; et
- un comparateur (212) configuré pour comparer, suite à une ou plusieurs des impulsions du premier signal, la valeur de la tension (VbatA) à travers la charge capacitive avec une première valeur seuil de tension (*V_{out_th}*),
le circuit de commande étant en outre configuré pour, si la première valeur seuil de tension est dépassée, appliquer un deuxième signal d'impulsions formé de deuxièmes impulsions consécutives de tension séparées par un deuxième temps de repos, vers la grille du transistor de puissance alimentant la charge capacitive du circuit, le deuxième temps de repos étant inférieur au premier temps de repos;
le circuit étant **caractérisé en ce que** le circuit de commande est en outre configuré pour, suite à une ou plusieurs des impulsions du deuxième signal, comparer la valeur de la tension (VbatA) à travers la charge capacitive avec la première valeur seuil de tension (*V_{out_th}*), et si la valeur de tension est inférieure ou égale à la première valeur seuil de tension, commander l'arrêt du deuxième signal d'impulsions.

11. Système (100) comprenant :
- un transformateur (114) configuré pour alimenter un boitier de commutation (112) ;
- le boitier de commutation comprenant le circuit (200) de la revendication 10.

12. Système selon la revendication 11, dans lequel le transformateur (114) et le boitier de commutation (112) font partie d'une automobile.

## Patentansprüche

1. Verfahren zum elektrischen Hochfahren einer Schaltung (200), wobei das Verfahren folgendes aufweist:
- Anlegen, durch eine Steuerschaltung (206), eines ersten gepulsten Signals, bestehend aus sequenziellen ersten Spannungsimpulsen, an das Gate eines Leistungstransistors (202), wobei der Leistungstransistor eine kapazitive Last der Schaltung (104) versorgt, wobei die Impulse des ersten gepulsten Signals durch eine erste Wartezeit beabstandet sind;
- nach einem oder mehreren Impulsen des ersten Signals, einen Vergleich, durch einen Komparator (212), des Spannungswerts (VbatA) über der kapazitiven Last mit einem ersten Spannungsschwellenwert (*V_{out_th}*); und
- falls der erste Spannungsschwellenwert überschritten wird, Anlegen, durch die Steuerschaltung, eines zweiten gepulsten Signals, bestehend aus sequenziellen zweiten Spannungsimpulsen, an das Gate des Leistungstransistors, der die kapazitive Last der Schaltung versorgt, wobei die Impulse des zweiten gepulsten Signals durch eine zweite Wartezeit beabstandet sind, die kürzer als die erste Wartezeit ist;
- **dadurch gekennzeichnet, dass** das Verfahren ferner folgendes aufweist:
- nach einem oder mehreren Impulsen des zweiten Signals, einen zweiten Vergleich, durch den Komparator, des Spannungswerts über der kapazitiven Last mit dem ersten Spannungsschwellenwert;
- falls während des zweiten Vergleichs der Wert der Spannung kleiner als oder gleich dem ersten Spannungsschwellenwert ist, Stoppen, durch die Steuerschaltung, des zweiten gepulsten Signals.

2. Verfahren nach Anspruch 1, ferner folgendes aufweisend:
- nach einem oder mehreren Impulsen des zweiten Signals, einen Vergleich, durch den Komparator (212), des Spannungswerts (VbatA) über der kapazitiven Last (104) mit einem zweiten Spannungsschwellenwert (Vmax);
- falls der Wert der Spannung gleich oder größer als der zweite Spannungsschwellenwert ist, Stoppen, durch die Steuerschaltung (206), des zweiten gepulsten Signals.

3. Verfahren nach Anspruch 1 oder 2, ferner folgendes aufweisend:
- nach einem oder mehreren Impulsen des ersten gepulsten Signals und falls der Spannungswert (VbatA) über der kapazitiven Last (104) kleiner als der erste Spannungsschwellenwert (*V_{out_th}*) ist, Inkrementieren, unter Verwendung eines Zählers der Schaltung, eines ersten Zählwerts (COUNT); und
- falls der Zählwert gleich einem ersten Referenzwert ist, Stoppen, durch die Steuerschaltung (206), des ersten gepulsten Signals.

4. Verfahren nach einem der Ansprüche 1 bis 3, ferner folgendes aufweisend:
- nach einem oder mehreren Impulsen des zweiten gepulsten Signals, Inkrementieren, unter Verwendung eines Zählers der Schaltung, eines zweiten Zählwerts; und
- falls der zweite Zählwert gleich einem zweiten Referenzwert ist, Stoppen, durch die Steuerschaltung (206), des zweiten gepulsten Signals.

5. Verfahren nach einem der Ansprüche 1 bis 4, wobei die Steuerschaltung (206) jeden Impuls des ersten gepulsten Signals an den Leistungstransistor (202) anlegt, durch Durchführen von folgendem:
- Anlegen einer ersten Flanke, die den Leistungstransistor einschaltet;
- Überprüfen, durch eine Detektionsschaltung (208), eines ersten Stromniveaus (ILOAD), der durch den Leistungstransistor geleitet wird; und
- wenn das erste Stromniveau ein Schwellenniveau (OVERCURRENT) erreicht, Anlegen einer zweiten Flanke, die den Leistungstransistor ausschaltet.

6. Verfahren nach Anspruch 5, wobei die Steuerschaltung (206) jeden Impuls des zweiten gepulsten Signals an den Leistungstransistor (202) anlegt, durch Durchführen von folgendem:
- Anlegen einer dritten Flanke, die den Leistungstransistor einschaltet;
- Überprüfen, durch die Detektionsschaltung (208), eines zweiten Stromniveaus (ILOAD), der durch den Leistungstransistor geleitet wird; und
- wenn das zweite Stromniveau das Schwellenniveau (OVERCURRENT) erreicht, Anlegen einer vierten Flanke, die den Leistungstransistor ausschaltet.

7. Verfahren nach Anspruch 5 oder 6, wobei das Schwellenniveau (OVERCURRENT) einem Stromniveau entspricht, bei dem der Temperaturkoeffizient des Leistungstransistors (202) negativ ist.

8. Verfahren nach einem der Ansprüche 1 bis 7, wobei die Steuerschaltung (206) jeden Impuls des ersten gepulsten Signals an den Leistungstransistor (202) anlegt, durch Durchführen von folgendem:
- Anlegen einer ersten Flanke, die den Leistungstransistor einschaltet;
- Vergleichen, durch einen Thermosensor (214) der Schaltung (200), der Temperatur des Leistungstransistors (202); und
- wenn die Temperatur des Transistors eine Schwellentemperatur erreicht, Anlegen einer zweiten Flanke, die den Leistungstransistor ausschaltet.

9. Verfahren nach einem der Ansprüche 1 bis 8, wobei wenigstens ein Wert aus: dem ersten Spannungsschwellenwert (*V_{out_th}*) ; dem Wert der ersten Wartezeit; und dem Wert der zweiten Wartezeit durch einen Wert bestimmt wird, der in einem programmierbaren Speicher der Schaltung gespeichert ist.

10. Schaltung (200), die folgendes aufweist:
- einen Leistungstransistor (202), der konfiguriert ist zum Versorgen einer kapazitiven Last (104) der Schaltung;
- eine Steuerschaltung (206), die konfiguriert ist zum Anlegen eines ersten gepulsten Signals, bestehend aus sequenziellen ersten Spannungsimpulsen, die durch eine erste Wartezeit beabstandet sind, an das Gate eines Leistungstransistors; und
- einen Komparator (212), der konfiguriert ist zum Vergleichen, nach einem oder mehreren Impulsen des ersten Signals, des Spannungswerts (VbatA) über der kapazitiven Last mit einem ersten Spannungsschwellenwert (*V_{out_th}*)*,*
wobei die Steuerschaltung ferner konfiguriert ist, falls der erste Spannungsschwellenwert überschritten wird, zum Anlegen eines zweiten gepulsten Signals, bestehend aus sequenziellen zweiten Spannungsimpulsen, die durch eine zweite Wartezeit beabstandet sind, an das Gate des Leistungstransistors, der die kapazitive Last der Schaltung versorgt, wobei die zweite Wartezeit kürzer als die erste Wartezeit ist;
wobei die Schaltung **dadurch gekennzeichnet ist, dass** die Steuerschaltung ferner konfiguriert ist, nach einem oder mehreren Impulsen des zweiten Signals, zum Vergleichen des Spannungswerts (VbatA) über der kapazitiven Last mit dem ersten Spannungsschwellenwert (*V_{out_th}*), und falls der Wert der Spannung kleiner als oder gleich dem ersten Spannungsschwellenwert ist, zum Stoppen des zweiten gepulsten Signals.

11. System (100), das folgendes aufweist:
- einen Transformator (114), der konfiguriert ist zum Versorgen eines Schaltkastens (112);
- wobei der Schaltkasten die Schaltung (200) nach Anspruch 10 aufweist.

12. System nach Anspruch 11, wobei der Transformator (114) und der Schaltkasten (112) Teile eines Kraftfahrzeugs sind.

## Claims

1. A method for electrical power-up of a circuit (200), the method comprising:
- the application, by a control circuit (206), of a first pulsed signal, consisting of sequential first voltage pulses, towards the gate of a power transistor (202), the power transistor supplying a capacitive load of the circuit (104), the pulses of the first pulsed signal being distant by a first wait time;
- after one or more pulses of the first signal, a comparison, by a comparator (212), of the voltage value (VbatA) across the capacitive load with a first voltage threshold value (*V_{out_th}*); and
- if the first voltage threshold value is exceeded, the application, by the control circuit, of a second pulsed signal, consisting of sequential second voltage pulses, to the gate of the power transistor supplying the capacitive load of the circuit, the pulses of the second pulsed signal being distant by a second wait time shorter than the first wait time; **characterized in that** the method further comprises:
- after one or more pulses of the second signal, a second comparison, by the comparator, of the voltage value across the capacitive load with the first voltage threshold value;
- if during the second comparison, the value of the voltage is smaller than or equal to the first voltage threshold value, the stop, by the control circuit, of the second pulsed signal.

2. The method according to claim 1, further comprising:
- after one or more pulses of the second signal, a comparison, by the comparator (212), of the voltage value (VbatA) across the capacitive load (104) with a second voltage threshold value (Vmax);
- if the value of the voltage is equal to or greater than the second voltage threshold value, the stop, by the control circuit (206), of the second pulsed signal.

3. The method according to claim 1 or 2, further comprising:
- after one or more pulses of the first pulsed signal and if the voltage value(VbatA) across the capacitive load (104) is smaller than the first voltage threshold value (*V_{out_th}*), the incrementation using a counter of the circuit, of a first count value (COUNT); and
- if the count value is equal to a first reference value, the stop, by the control circuit (206), of the first pulsed signal.

4. The method according to any of claims 1 to 3, further comprising:
- after one or more pulses of the second pulsed signal, the incrementation using a counter of the circuit, of a second count value; and
- if the second count value is equal to a second reference value, the stop, by the control circuit (206), of the second pulsed signal.

5. The method according to any of claims 1 to 4, wherein the control circuit (206) applies each pulse of the first pulsed signal to the power transistor (202), by performing:
- the application of a first edge causing the power transistor on;
- the verification, by a detection circuit (208), of a first current level (ILOAD) conducted by the power transistor; and
- when the first current level reaches a threshold level (OVERCURRENT), the application of a second edge causing the power transistor off.

6. The method according to claim 5, wherein the control circuit (206) applies each pulse of the second pulsed signal to the power transistor (202), by performing:
- the application of a third edge causing the power transistor on;
- the verification, by the detection circuit (208), of a second current level (ILOAD) conducted by the power transistor; and
- when the second current level reaches the threshold level (OVERCURRENT), the application of a fourth edge causing the power transistor off.

7. The method according to claim 5 or 6, wherein the threshold level (OVERCURRENT) corresponds to a current level at which the thermal coefficient of the power transistor (202) is negative.

8. The method according to any of claims 1 to 7, wherein the control circuit (206) applies each pulse of the first pulsed signal to the power transistor (202), by performing:
- the application of a first edge causing the power transistor on;
- the comparison, by a thermal sensor (214) of the circuit (200), of the temperature of the power transistor (202); and
- when the temperature of the transistor reaches a threshold temperature, the application of a second edge causing the power transistor off.

9. The method according to any of claims 1 to 8, wherein, at least one value among: the first voltage threshold value (*V_{out_th}*); the value of the first wait time; and the value of the second wait time are determined by a value stored in a programmable memory of the circuit.

10. Circuit (200) comprising:
- a power transistor (202) configured to supply a capacitive load (104) of the circuit;
- a control circuit (206) configured to apply a first pulsed signal consisting of sequential first voltage pulses distant by a first wait time, to the gate of a power transistor; and
- a comparator (212) configured to compare, further to one or more pulses of the first signal, the voltage value (VbatA) across the capacitive load with a first voltage threshold value (*V_{out_th}*),
the control circuit being further configured to, if the first voltage threshold value is exceeded, apply a second pulsed signal, consisting of sequential second voltage pulses distant by a second wait time, to the gate of the power transistor supplying the capacitive load of the circuit, the second wait time being shorter than the first wait time; the circuit being **characterized in that** the control circuit is further configured to, further to one or more pulses of the second signal, compare the voltage value (VbatA) across the capacitive load with the first voltage threshold value (*V_{out_th}*), and if the value of the voltage is smaller than or equal to the first voltage threshold value, stop the second pulsed signal.

11. A system (100) comprising:
- a transformer (114) configured to supply a switch box (112);
- the switch box comprising the circuit (200) according to claim 10.

12. The system according to claim 11, wherein the transformer (114) and the switch box (112) are parts of an automotive vehicle.
